# EUROPEAN PATENT APPLICATION

(11) **EP 1 534 049 A2**
(43) Date of publication of application: **25.05.2005**
(21) Application number: 04027753.5
(22) Date of filing: 23.11.2004
(51) Int. Cl.: H05B 33/12, H05B 33/14

(54) **Lighting unit**

(30) Priority: 24.11.2003 JP 2003435331; 02.02.2004 JP 2004024947
(71) Applicant: Kabushiki Kaisha Toyota Jidoshokki, Kariya-shi, Aichi-ken (JP)
(72) Inventor: Takeuchi, Norihito K.K. Toyota Jidoshokki, Kariya-shi Aichi-ken (JP)
(74) Representative: Leson, Thomas Johannes Alois, Dipl.-Ing.

(57) **Abstract**

A lighting unit includes a plurality of panels and a light scattering means. The panels are arranged adjacently. Each panel has a transparent substrate and an electroluminescent element that is provided on the transparent substrate. Each panel also has end faces. The adjacent panels are arranged so that the end faces thereof face each other. The light scattering means is interposed between at least the end faces of the adjacent panels.

## Description

### BACKGROUND OF THE INVENTION

The present invention relates to a lighting unit.

A lighting unit in which electroluminescent element (EL element) is installed on a transparent substrate has been proposed heretofore. The lighting unit is adopted, for example, as a backlight of a liquid crystal display unit. The lighting unit requires the EL element to have a relatively large area. Since the EL element is extremely thin and the thickness of a layer thereof is about a few dozen nm to about a few hundred nm, it is difficult to uniformly form the EL layer with a wide area. As a result, a manufactured product could have unevenness of brightness or a portion thereof which does not emit light. Thus, the yield of the product becomes low.

In view of the above problem, various prior art solutions have been proposed to widen a light exit area by arranging a plurality of panels (cell, EL panel) in each of which the EL element is formed on the transparent substrate.

For example, a first prior art solution with a display unit and an EL panel each having a large area that are manufactured by regarding the EL element as a cell functioning as one unit, and by arranging a large number of the cells has been proposed. (For example, refer to Document 1)

Also, a second prior art solution with an EL display unit having a large area that is constructed by joining a plurality of EL display panels with an adhesive, wherein joints of the adjacent EL panels thereof are obscured, has been proposed. (For example, refer to Document 2)

The EL display unit according to the second prior art solution is formed by joining four small-sized panels each consisting of a glass substrate; ITO (Indium Tin Oxide) that functions as a scanning picture electrode; an organic EL luminous layer; and a metallic electrode that functions as a signal picture electrode, thereby forming the EL display unit that is larger than the small-sized panel. Also, the small-sized panels are joined together with an adhesive. The adhesive employed is made by adjusting the wavelength-dispersion of its refractive index that coincides with the refractive index of the glass substrate in the range of a shorter wavelength, that is, for example, ranging from 400 nm to 600 nm, inclusive of 400 nm and 600 nm, where a visible light range is divided into two. As the adhesive, one of an ultraviolet curing adhesive, a large molecular adhesive and the like is used, or an adhesive such that two or more kinds of adhesives whose refractive indexes are different from each other are mixed is mentioned.

In a case where a lighting unit having a large display area is manufactured using the above-mentioned prior art solutions, a problem of variation in brightness (an amount of light emission) between the adjacent panels is inevitable.

Each panel requires an electrode of an electric terminal and an electrode connecting wire for connecting an anode and a cathode to an external circuit for driving. The electrode of the electric terminal and electrode connecting wire are generally provided about a portion (a periphery) of a substrate on which the EL element is formed. Therefore, even if the EL element is luminous, since light is not emitted from the portion of the substrate, or the periphery of the substrate, the portion of the substrate becomes dark. Accordingly, in a case where a lighting unit having a large area is manufactured by arranging a plurality of EL elements, a space between the adjacent EL elements becomes dark.

Thus, since the lighting unit manufactured has a portion from which light is emitted (a portion in which an EL element is provided) and a portion from which light is not emitted (a portion in which an EL element is not provided), there is an extremely high possibility that defects of display, such as unevenness of brightness or a dark line, is visually confirmed.

To solve this problem, an EL display unit according to a third prior art solution has been proposed. In the third prior art solution, by superimposing one EL sheet over a part of the periphery of another EL sheet, in a joint of adjacent EL sheets, the above-mentioned peripheral electrode is omitted from at least a portion of the EL sheet, which is superimposed over the above-mentioned another EL sheet, thereby emitting light evenly from the end of the EL sheet. (For example, refer to Document 3)

It is noted that Document 1 is Japanese Unexamined Patent Publication No. 2001-52858. (Specifically, refer to paragraphs [0008] and [0009] of the specification)

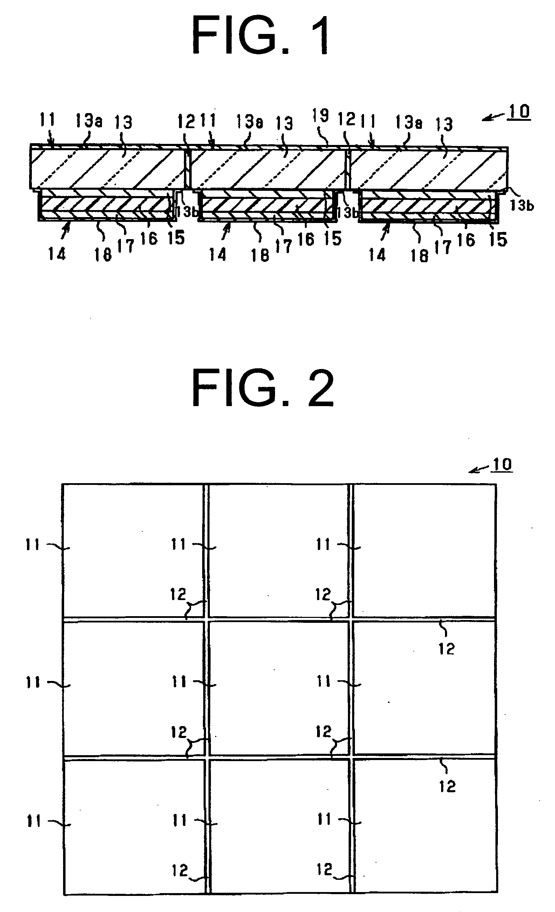

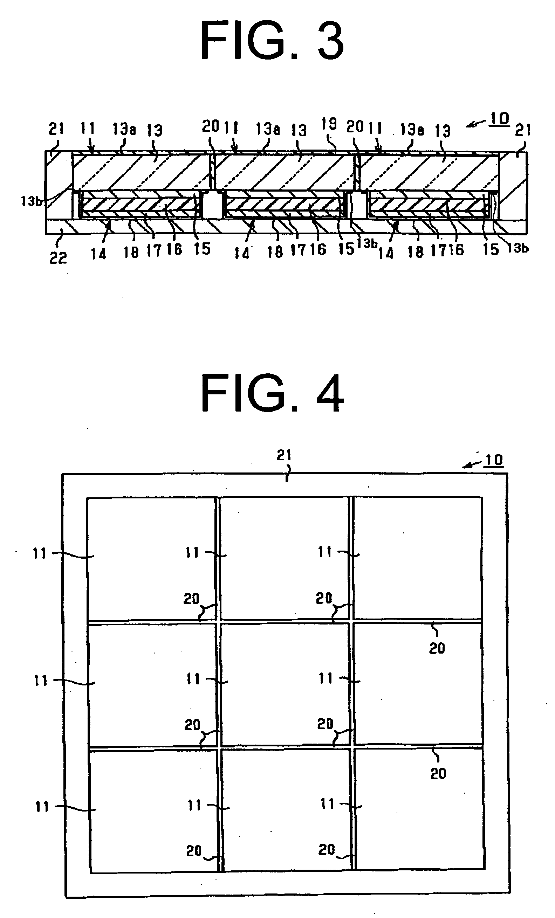

It is also noted that Document 2 is Japanese Unexamined Patent Publication No. 2001-175204. (Specifically, refer to paragraphs [0035] and [0036] of the specification, and figures 1 and 3)

It is also noted that Document 3 is Japanese Unexamined Patent Publication No. 2001-126871. (Specifically, refer to paragraphs [0008], [0009], [0018] and [0020] of the specification)

However, since the third prior art solution needs to "superimpose" one EL sheet over another EL sheet, in order to manufacture a lighting unit whose light exit surface is flat, a substrate of the EL sheet needs to adopt a flexible material, such as film made of polyethylene terephthalate. In addition, for a portion where two sheets are superimposed, since at least one sheet needs to be bent so as to be located at the "backside" of another sheet or the "downside" thereof, stress is applied to each layer of the organic EL element at least in the portion. Therefore, a material or a manufacturing method which does not affect luminous performance, even in a case where the sheet is bent, needs to be selected. Thus, in a case where the third prior art solution is adopted, adoptable materials or manufacturing methods are extremely limited.

In addition, for the third prior art solution, the end (the peripheral electrode or the adjacent organic EL element) of one sheet, which is superimposed, needs to be "cut off" by a cutter. Meanwhile, the organic EL element generally transforms or deteriorates by air or water content. Therefore, when the organic EL element is applied to the third prior art solution, a cut surface of the organic EL element needs to be protected separately. Since there is a possibility that the organic EL element transforms by pressure or heat which is given when the organic EL element is cut, a cutting means such as cutter needs to be selected and a material or a manufacturing method which is not harmfully affected by cutting needs to be selected. Thus, adoptable materials or manufacturing methods may be further limited.

Further, there is a problem that each EL sheet does not have the identical shape. Although the third prior art solution adopts the identical EL sheets, the ends of the EL sheets need to be "cut off' in accordance with positions in which the EL sheets are arranged. In the third prior art solution, concrete examples are variously introduced. However, in view of the lighting unit manufactured, each sheet has a different shape. That is, the shape (structure) of the EL sheet needs to be changed in accordance with the positions in which the EL sheets are arranged. Therefore, the EL sheets of the third prior art solution need to be manufactured by arranging a plurality of sheets, whose shapes are substantially different, in predetermined positions and by combining them.

For the manufactured lighting unit, in a case where one EL sheet or a plurality of EL sheets is exchanged, the sheet having the identical shape to that of the original sheet needs to be prepared.

### SUMMARY OF THE INVENTION

The present invention is directed to a lighting unit which reduces differentials of brightness in a space between panels and brightness in another place.

The present invention provides a first lighting unit. The first lighting unit includes a plurality of panels and a light scattering means. The panels are arranged adjacently. Each panel has a transparent substrate and an electroluminescent element that is provided on the transparent substrate. Each panel also has end faces. The adjacent panels are arranged so that the end faces thereof face each other. The light scattering means is interposed between at least the end faces of the adjacent panels.

The present invention also provides a second lighting unit. The second lighting unit includes a plurality of panels and a light scattering structure. The panels are arranged adjacently. Each panel has a transparent substrate, which has on opposite sides thereof a light exit surface and a light incidence surface. Each panel also has an electroluminescent element that is provided on the light incidence surface of the transparent substrate. Each panel further has end faces. The light exit surfaces or the light incidence surfaces are positioned roughly in the identical plane. Each electroluminescent element is located so as to exist on the same side relative to the plane. The light scattering structure is provided on the end face of each transparent substrate, thereby extracting the light that is emitted from the electroluminescent element from a side of the light exit surface to an outside of the lighting unit.

The present invention further provides a third lighting unit. The third lighting unit includes a plurality of panels. The panels are arranged adjacently. Each panel has a transparent substrate, which has on opposite sides thereof a light exit surface and a light incidence surface. Each panel also has an electroluminescent element that is provided on the light incidence surface of the transparent substrate. Each panel further has end faces. The light exit surfaces or the light incidence surfaces are positioned roughly in the identical plane. Each electroluminescent element is located so as to exist on the same side relative to the plane. The third lighting unit also includes a scattering member provided on a side of the light exit surface of the transparent substrate and/or uneven portions formed on the light exit surface.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention, together with objects and advantages thereof, may best be understood by reference to the following description of the presently preferred embodiments, together with the accompanying drawings, in which:
FIG 1 is a schematic sectional view illustrating a lighting unit according to a first preferred embodiment of the present invention;
FIG 2 is a schematic plan view illustrating the lighting unit according to the first preferred embodiment of the present invention;
FIG 3 is a schematic sectional view illustrating a lighting unit according to a second preferred embodiment of the present invention;
FIG. 4 is a schematic plan view illustrating the lighting unit according to the second preferred embodiment of the present invention;
FIG. 5 is a schematic sectional view illustrating a lighting unit according to a third preferred embodiment of the present invention;
FIG. 6 is a schematic plan view illustrating the lighting unit according to the third preferred embodiment of the present invention;
FIG. 7 is a schematic sectional view illustrating a lighting unit according to a fourth preferred embodiment of the present invention; and
FIG. 8 is a schematic plan view illustrating the lighting unit according to the fourth preferred embodiment of the present invention.

### DETAILED DESCRIPTION OF THE PREFERRED EMBODIMENTS

A lighting unit according to a first preferred embodiment of the present invention will now be described with reference to FIGS. 1 and 2. FIG. 1 is a schematic sectional view illustrating the lighting unit according to the first preferred embodiment of the present invention. FIG. 2 is a schematic plan view illustrating the lighting unit according to the first preferred embodiment of the present invention.

First, the structure of the lighting unit will be described. As shown in FIG, 2, a lighting unit 10 is formed by arranging a plurality of panels 11 and by joining them. In the present embodiment, the number of panels 11 which have roughly the same structure is nine, and the nine panels 11 are arranged in the shape of a matrix of three rows and three columns. The adjacent panels 11 are joined to each other by a congealed member (an adhesives) 12 that serves as a light scattering means so that at least transparent substrates of the adjacent panels 11 are respectively joined to each other.

The panel 11 includes a transparent substrate 13 and an organic electroluminescent (EL) element 14 formed on the transparent substrate 13. The organic EL element 14 functions as an EL element. The panel 11 is constructed so that the light emitted from the organic EL element is extracted (or emitted) to the outside of the lighting unit 10 through the transparent substrate 13. That is, the panel 11 is a bottom emission type of organic EL device.

It is noted that the arrangement of the panel 11 is not limited to the shape of the matrix of three rows and three columns, and the panel 11 may be arranged in one column, two columns, four columns or more than four columns. In addition, the number of panels 11 is capable of being optionally varied in accordance with an irradiating area at which the lighting unit 10 aims.

Constituent elements of the lighting unit 10 are explained in detail below.

The transparent substrate 13 only requires including a light exit surface 13a and a light incidence surface 13b that are arranged on the opposite sides thereof roughly parallel with each other. A transparent substrate for use in a heretofore known organic EL element is suitably adopted. For example, a substrate which includes a glass or a transparent resin may be selected. Also, a substrate which is manufactured by layering the same kind of materials or different kinds of materials may be adopted.

The organic EL element 14 is constructed so that a first electrode 15, an organic EL layer 16, and a second electrode 17 are layered one after another. The organic EL element 14 is preferably covered with a protective film 18 so that the organic EL layer 16 is not exposed to air.

One of the first electrode 15 and the second electrode 17 constructs the anode, and the other constructs the cathode.

The first electrode 15 is a transparent electrode, and is arranged on the side of the organic EL layer 16 from which light is extracted. That is, the first electrode 15 is a transparent electrode which has a light permeation performance, and is formed on the side in which light is extracted. The other electrode, or the second electrode 17, is generally a reflecting electrode which has a light reflection performance.

The first electrode 15 is made of a transparent conductive material such as ITO or IZO. The first electrode 15 also may be made of a metal such as aluminum or chromium, or an alloy of aluminum and chromium having a film thickness which enables light to permeat the metal or the alloy. When the first electrode 15 is thus made of metal or alloy, the film thickness of these layers or metallic layers is generally 50 nm or below. More preferably, the film thickness ranges between 0.5 and 20 nm.

The second electrode 17 only requires being made of a conductive material, which injects a carrier into the organic EL layer 16. In a case where the second electrode 17 is the reflecting electrode as mentioned above, a material for forming a second electrode of a heretofore known organic EL element is suitably adopted. The material for forming the second electrode is, for example, a metal such as aluminum or chromium, or an alloy of aluminum and chromium, or a macromolecular conductive material. Naturally, a transparent substrate may be adopted as the second electrode similarly to the first electrode. Further, an electrode which is constructed by layering the same kind of materials or different kinds of materials may be adopted.

In comparison between a work function of a material adopted as the first electrode 15 and that of a material adopted as the second electrode 17, it is generally preferable that the first electrode 15 is the anode and the second electrode 17 is the cathode.

For the organic EL layer 16, an organic EL layer for use in a heretofore known organic EL element is selected. The organic EL layer 16 at least includes a luminous layer containing an organic luminous material such as Alq3, DCM1 or coumarin derivative. In addition, the organic EL layer 16 may be a single-layer structure constructed only by a luminous layer. Alternatively, the organic EL layer 16 may a multilayered structure including various functional layers having a luminous function. For example, the organic EL layer 16 may be constructed so that a hole injection layer, a luminous layer, and an electron injection layer are layered from the side of the first electrode 15 one after another. The organic EL layer 16 also may be constructed so that a hole injection layer, a hole transport layer, a luminous layer and an electron transport layer are layered from the side of the first electrode 15 one after another. The organic EL layer 16 is constructed so as to emit, for example, while light. In this case, when the lighting unit 10 is used as a backlight of a liquid crystal display unit, the lighting unit 10 is adaptable to a full-color display using a color filter.

Each functional layer constructing the organic EL layer 16 may be constructed by a single layer, or by a plurality of layers. Therefore, for example, the luminous layer may be constructed by a plurality of layers. In a case where the luminous layer is thus constructed by a plurality of layers, the organic EL element 14 emitting white light may be formed by layering a layer emitting red light, a layer emitting green light, and a layer emitting blue light. The organic EL layer 16 is not limited to emitting white light. For example, monochromatic light such as red, blue, green or yellow, or light of a combination of red, blue, green, and yellow may be emitted. Naturally, the organic EL element 14 may be a layer that emits light of other colors. Further, a lighting unit that emits light having a plurality of wavelengths is manufactured by arranging the aforementioned layers (luminous layers in a narrow sense).

The adjustment of the luminous color is suitably performed by the following techniques. A material which the luminous layer is to contain is selected. A film thickness of each layer constructing the organic EL layer 16 including the luminous layer is adjusted. A voltage applied to the organic EL element 14 is adjusted. A wavelength transformation layer is arranged on the layer on a light extracting side from the luminous layer. It is noted that the layer on the light extracting side from the luminous layer includes layers other than the organic EL layer 16 such as a transparent substrate.

In addition, in order to enhance the purity of light emitted from the lighting unit 10 to the outside thereof, a color filter may be used. In this case, an image may be displayed by arranging a liquid crystal display panel on the light extracting side of the organic EL element 14, and by adjusting an amount of light emitted from various positions (picture element, sub-pixel). The liquid crystal display panel functions as a shutter means for adjusting an amount of permeating light. That is, the lighting unit 10 may be used as a backlight of the liquid crystal display panel. Further, the lighting unit 10 may be used as a luminous source for another lighting unit or another display unit.

A plurality of the organic EL elements 14 may be electrically connected in series. The plurality of organic EL elements 14 includes all the organic EL elements 14. In such a construction, the same amount of electric current passes through the organic EL elements14 which are connected in series, thereby being capable of roughly equalizing an amount of light emitted from each organic EL element 14, for brightness of the organic EL element 14 is generally proportional to an amount of electric current passing through the organic EL element 14.

For elements, such as inorganic EL elements, driven by voltage, when the elements are connected in parallel, the same magnitude of voltage is applied to each element.

It is noted that a method of electrically connecting each organic EL element 14 is not limited to the above-mentioned example, and each organic EL element 14 may be driven independently. In addition, sets of the organic EL elements 14, which are connected to each other in series, may be connected in parallel. Further, sets of the organic EL elements 14, which are connected to each other in parallel, may be connected in series.

The protective film 18 is formed so as to cover portions other than the surfaces of the first electrode 15, the organic EL layer 16 and the second electrode 17, which are adjacent to each other. The protective film 18 is made of a material which at least prevents permeation of water content (water vapor) and oxygen. For the material of the protective film 18, for example, silicon oxide, silicon nitride and polysilazane are used. The protective film 18 can have another function that protects the organic EL element 14 from external pressure. Also, the protective film 18 can have yet another function that protects the organic EL element 14 from gas other than the gas mentioned above.

It is noted that a sealed can may be provided in place of the protective film 18 (passivation film). Alternatively, the sealed can may be provided together with the protective layer 18.

As shown in FIG. 1, the lighting unit 10 is constructed so that each panel 11 adheres to the adjacent panels 11 at least in the end faces of the respective transparent substrates 13 by the adhesive 12 that functions as an adhesive means and also a light scattering means. The adhesive 12 is a solidified member thereof and is hereinafter referred to an adhesive.

The adhesive 12 functions as an adhesive means for joining the adjacent panels 11 and also functions as a light scattering means for scattering the light entered from the panel 11. The adhesive 12 closely adheres to the transparent substrate 13, and a large amount of the light which is emitted from portions of the transparent substrate 13 of the panel 11, other than the light exit surface 13a, reaches the end face of the transparent substrate 13. The light which has reached the end face of the transparent substrate 13 enters the adhesive 12. A traveling direction of the light thus having entered the adhesive 12 is varied by the light scattering means. A part of the light is emitted from the adhesive 12 to the outside of the lighting unit 10 (in a light exit direction), and another part of the light enters the transparent substrate 13 again. Since a traveling direction of the light having entered the transparent substrate 13 is varied relative to the light exit surface 13a by the light scattering means, a part of the light or all the light is emitted from the light exit surface 13a to the outside of the lighting unit 10.

The adhesive 12 contains in a main portion thereof a member such as transparent beads or air bubbles, whose refractive ratio is different from that of the main portion. The adhesive 12 also contains in the main portion thereof a member having a light reflecting performance, such as powdered ceramics or powdered metal. Thus, the adhesive 12 has a function for scattering light. In the present embodiment, when the adjacent panels 11 adhere to each other, the adhesive 12 does not perform an optical absorption. When the adhesive 12 congeals, the adhesive 12 becomes clouded. It is noted that the adhesive 12 does not need to become clouded when the adhesive 12 congeals. Unless the adhesive 12 absorbs light, the adhesive 12 is capable of having a light scattering function by scattering particulates which reflect or refract light.

It is also noted that a reflecting member may be provided on the side of the light incidence surface 13b of the adhesive 12 relative to the transparent substrate 13.

On the light exit surface 13a of the transparent substrate 13, a scattering member 19 is preferably adhered. The scattering member 19 may be only mounted on the light exit surface 13a of the transparent substrate 13. The scattering member 19 scatters the light emitted from the light exit surface 13a or the adhesive 12. For the scattering member 19, for example, a prism sheet, a transparent plate that contains therein a scattering member, and a transparent plate that has formed on the surface thereof unevenness having sufficient size to be capable of scattering light are used.

It is noted that the scattering member 19 is preferably closely applied to the light exit surface 13a of the transparent substrate 13 and/or the side of the light exit surface of the adhesive 12. Thus, in such a state that the scattering member 19 is closely applied, the amount of light reflected on the light incidence side of the scattering member 19 is extremely reduced.

Operation of the lighting unit 10 will now be explained.

For the organic EL element 14 of the lighting unit 10, a voltage is applied between the first electrode 15 and the second electrode 17 by a drive control unit, which is not shown. Thus, the organic EL layer 16 emits light. That is, light is emitted from the organic EL layer 16. The organic EL element 14 generally has isotropic light emitting characteristics. When each position of the organic EL layer 16 is regarded as a point light source, roughly the same amount of light is emitted from the position to all directions. The light thus emitted is emitted to the outside of the lighting unit 10 through the following route in accordance with the traveling direction.

### (I) The light which has entered from the organic EL layer 16 into the transparent substrate 13 through the first electrode 15

The light which has reached the light exit surface 13a of the transparent substrate 13 at an angle smaller than the critical angle of the transparent substrate 13 is extracted from the light exit surface 13a to the outside of the lighting unit 10. The light which has reached the light exit surface 13a at an angle larger than the critical angle is totally reflected on the light exit surface 13a toward the organic EL element 14. The light which has been thus totally reflected is guided through the transparent substrate 13, and a part of the light or all the light enters the adhesive 12 functioning as a light scattering means. That is, the light whose incidence angle is smaller than the critical angle determined by a refractive index of the transparent substrate 13 and a refractive index of the scattering member 19, among the light which has entered the transparent substrate 13, is emitted from the light exit surface 13a. On the other hand, the light whose incidence angle is equal to or larger than the critical angle is totally reflected on the light exit surface 13a, and a large amount of the light is guided through the transparent substrate 13. The light, which is guided through the transparent substrate 13, travels through the end face of the transparent substrate 13 into the adhesive 12 between the adjacent panels 11.

### (II) The light which has not been capable of entering from the first electrode 15 to the transparent substrate 13

Such light is guided through the organic EL element 14, and a part of the light enters the adhesive 12.

### (III) The light which has been emitted from the organic EL element 16 toward the second electrode 17

In a case where the second electrode 17 is a reflecting electrode, almost all the above-mentioned light is reflected toward the organic EL layer 16. Also, in a case where the second electrode 17 is not a reflecting electrode, the light whose incidence angle is larger than the critical angle on an interface between the organic EL layer 16 and the second electrode 17 (or a face in the second electrode 17 facing the above interface) is reflected toward the organic EL layer 16. The light which has been thus reflected totally or partially follows the route mentioned in the above-operation (I) or (II).

### (IV) The light which has entered the adhesive 12

The light which has entered the adhesive 12 is partially or totally scattered by a light scattering means. The light whose traveling direction is varied toward the light extracting side of the lighting unit 10 is emitted from the adhesive 12 to the outside of the lighting unit 10. That is, the light which has reached the light scattering means is scattered, and a part of the light is emitted from the side of the light exit surface 13a.

For example, a large amount of light, which is totally reflected on the light exit surface 13a, among the light that has entered from the organic EL element 14 to the transparent substrate 13 is guided through the transparent substrate 13, and is emitted from the end portions of the transparent substrate 13, and therefore, such light could not be utilized (extracted) heretofore. In the present embodiment, however, the light travels from the end faces of the transparent substrate 13 into the adhesive 12 between the adjacent panels 11. The light which reaches the light scattering means, among the light that has traveled into the adhesive 12, is scattered, and is emitted from the light exit surface 13a.

The light other than the above-mentioned light enters the adjacent transparent substrate 13 or the organic EL element 14, and follows the route mentioned in the above-operation (I) or (II). The light in the adhesive 12, which has traveled toward the opposite side of the light exit surface 13a, is reflected toward the light exit surface 13a, when the aforementioned reflecting member is provided on the opposite side. The light that has been thus reflected is partially or totally emitted from the light exit surface 13a to the outside of the lighting unit 10. The light that has not been emitted to the outside of the lighting unit 10 enters the adjacent transparent substrate 13 or the organic EL element 14, and follows the route mentioned in the above-operation (I) or (II).

It is noted that in a case where the scattering member 19 is provided on the lighting unit 10, the light which has been emitted from the light exit surface 13a to the outside of the lighting unit 10 is scattered (diffused) by the scattering member 19.

The lighting unit 10 has the above operation, and has the following beneficial effects.
(1) The light is emitted from the whole area of the light exit surface 13a

As described above, this is because the light is emitted evenly from the portions (the peripheral portions of the panel 11, joints connecting the adjacent panels 11, space between the adjacent panels 11, and the adhesive 12) of the lighting unit 10, in which the organic EL element 14 is not provided, thereby preventing the peripheral portion of each panel 11, and the joints connecting each panel 11, from becoming extremely dark in comparison with a portion of the panel 11 in which the organic EL element 14 is provided. In addition, an equal amount of light is emitted from the peripheral portion of each panel 11 and the joints connecting each panel 11. That is, unevenness of brightness is prevented in comparison with the lighting unit 10 in which only the panels 11 are arranged without using the adhesive 12.

Additionally, since the scattering member 19 is placed on the light exit surface 13a of the transparent substrate 13, differential of brightness between a portion of the lighting unit 10 in which the organic EL element 14 is provided, and the peripheral portions and the joints of the panels 11 of the lighting unit 10 is further reduced.

This effect is obtained by providing the adhesive 12 functioning as a light scattering means in the lighting unit 10, and by using the bottom emission type of organic EL device as the panel 11.

Since the bottom emission type of organic EL device is used, conception is changed as follows. The light, which was conventionally emitted from the end face of the transparent substrate 13 to the outside of the lighting unit 10 and was not utilized, is guided to the adhesive 12 through the transparent substrate 13, and then is emitted from the adhesive 12 to the outside of the lighting unit 10.
(2) Each panel 11 of the lighting unit 10 is formed so as to have roughly the identical structure. In addition, each panel 11 is installed in the lighting unit 10 without specially machining the panel 11 or damaging the panel 11.

This is because the panels 11 are joined to each other by the adhesive 12. Therefore, the manufacture of the lighting unit 10 is as whole easily performed, and the number of parts is substantially reduced. In addition, when an old panel 11 is replaced by a new panel 11, neither the type of the new panel 11 needs to be selected nor the new panel 11 needs to be machined.
(3) A luminous region according to the lighting unit 10 of the present embodiment is expanded compared to a lighting unit constructed by one organic EL element or one organic EL device.

As described above, although it is actually difficult to manufacture the organic EL element that has a relatively large luminous region, and, depending on the size of the region, it is substantially impossible to manufacture the organic EL element. Whereas, the lighting unit 10 of the present embodiment materializes a desired luminous region only by varying the number of panels 11.
(4) The yield of the lighting unit 10 of the present embodiment is improved compared to a lighting unit constructed by one organic EL element or one organic EL device.

In a case where a lighting unit having the same luminous region is manufactured, when the lighting unit is constructed by one organic EL element or one organic EL device, as described above, defects such as the unevenness of the brightness is caused, thereby enhancing the possibility of manufacturing an article that is not capable of being used as a product. Meanwhile, the lighting unit 10 of the present embodiment is formed so that a small-sized organic EL device 11 is manufactured and is constructed as described above, thereby extremely lowering the possibility of manufacturing an organic EL device that is not capable of being used as a product compared to the aforementioned example. Therefore, the yield of the lighting unit 10 is improved.
(5) The lifetime of the lighting unit 10 of the present embodiment is extended compared to that of the lighting unit constructed by one organic EL element or one organic EL device.

In a case where the lighting unit is constructed by one organic EL element, if unevenness of the brightness is caused and/or dark spots are generated, the lighting unit is not capable of being substantially used.

Meanwhile, for the lighting unit 10, even if the above-mentioned defects are caused on one of the panels 11, when the luminous region as a whole is viewed, it is substantially difficult to confirm the defects by viewing. Thus, the lifetime of the lighting unit 10 is capable of being extended from the above case.
(6) In comparison with a case where a plurality of organic EL devices are installed in predetermined positions of the lighting unit, the panels 11 are easily installed in the lighting unit 10. That is, the joined panels 11 are easily handled.

Consider a case where a plurality of organic EL devices are installed, for example, in a backlight of a liquid crystal display unit. Since the devices are respectively independent, in order to install these devices respectively in the predetermined positions, a special component which fixes a plurality of members in the predetermined positions is needed. In addition, every device needs an installing operation.

Meanwhile, for the lighting unit 10, each panel 11 is joined by the adhesive 12 functioning as an adhesive means. In a case where the joined panels 11 are installed in the backlight of the liquid crystal display unit as mentioned above, the joined panels 11 are fixed in the backlight using a member equal to a prior installing member. In addition, the lighting unit 10 is installed in the backlight as a unit. That is, since each panel 11 is joined by the adhesive 12 functioning as an adhesive means, in a case where the lighting unit 10 is installed, for example, in a liquid crystal display unit, the joined panels 11 are easily handled and the structure thereof is simplified.

Thus, no special component needs to be prepared in order to install the lighting unit 10 in the predetermined position. Similarly, no special installing method needs to be used.

Since the adhesive 12, which functions as an adhesive means, further functions as a light scattering means, in comparison with a case where the adhesive means and the light scattering means are separately provided in a lighting unit, the structure of the lighting unit 10 of the present embodiment is simplified.

It is noted that the above effects are obtained even if the light scattering means does not function as an adhesive means as described later.

Modified examples of the lighting unit 10 will now be explained. It is noted that the following modified examples are capable of being adopted by appropriately combining them so as not to conflict with each other. As a matter of course, the modified examples which have been already described are also capable of being appropriately adopted. It is also naturally possible to combine the aforementioned modified examples with the following modified examples.

The light scattering means 12 does not need to function as an adhesive. That is, the light scattering means 12 does not need to be constructed using an adhesive.

Specifically, the light scattering means 12 may be constructed by providing, in a transparent main constituent, a member such as beads or air bubble, whose refractive index is different from that of the main constituent. The light scattering means 12 may be arranged in a space between the transparent substrates 13. In addition, a portion of the main constituent, whose refractive index is different from that of the main constituent, may be manufactured by transforming the material of the main constituent by a laser marking method. Further, such light scattering means 12 may be adhered to the transparent substrate 13 by adhesive.

Instead of closely contacting the scattering member 19 with each transparent substrate 13, by forming, on the light exit surface 13a of the transparent substrate 13, a plurality of uneven portions each having sufficient size to be capable of scattering light, substantially equal effects are obtained.

An inorganic EL element may be used as an EL element. The inorganic EL element has between a first electrode and a second electrode an inorganic EL layer which is sandwiched by insulated layers. The inorganic EL layer contains therein a heretofore known inorganic luminous material.

A lighting unit according to a second preferred embodiment of the present invention will now be described with reference to FIGS. 3 and 4. FIG. 3 is a schematic sectional view illustrating the lighting unit according to the second preferred embodiment of the present invention. FIG. 4 is a schematic plan view illustrating the lighting unit according to the second preferred embodiment of the present invention. It is noted that the same numeric designations are used for components in common with the lighting unit according to the first preferred embodiment, and the detailed explanation in common with the first preferred embodiment is omitted.

The lighting unit of the second preferred embodiment is different from that of the first preferred embodiment in that a light scattering member (a gelled member) 20, which is formed mainly by gel or only by gel is used, as a light scattering means.

The light scattering member 20 is interposed between the end faces of the transparent substrates 13 of the adjacent panels 11. The lighting unit 10 has a flat frame 21 so that each panel 11 is pushed in a direction in which the adjacent panels 11 approach each other, and the lighting unit 10 provides a basal plate 22 on one side of the frame 21. The panels 11 are laid in the frame 21 so that the protective film 18 contacts the basal plate 22.

The light scattering member 20 has transparent particles scattered therein whose refractive index is different from that of the light scattering member 20 so as to function as a light scattering means. For the light scattering member 20, for example, a silicone gel has transparent particles scattered therein whose refractive index is different from that of the silicone gel, and the particles scatter light. Therefore, a scattering means provided in the gelled member 20 is capable of being kept in a certain place.

The lighting unit of the second preferred embodiment has the same effects as that of the first preferred embodiment. In addition, the lighting unit of the second preferred embodiment has the following beneficial effects.
(7) The amount of light which enters from the end face of the transparent substrate 13 into the light scattering member 20 is increased in comparison with a case that a solid light scattering member is used.

Since the light scattering member 20 is mainly made of gel, the light scattering member 20 is capable of closely contacting the end face of the transparent substrate 13, thereby substantially eliminating an interface between the light scattering member 20 and the transparent substrate 13.

That is, since the gelled member 20 is formed between the end faces of the transparent substrates 13 of the adjacent panels 11, the gelled member 20 is capable of filling a space between the adjacent panels 11. In other words, the gelled member 20 and the end face of the transparent substrate 13 are capable of being closely contacted with each other. Therefore, for the light which has entered from each organic EL element 14 to the transparent substrate 13, the light which travels to the light exit surface 13a at an angle equal to or more than the critical angle easily travels into the gelled member 20.

It is noted that the same effect as the effect (7) of the second preferred embodiment is obtained even if a gap exists in a space between the gelled member 20 and the transparent substrate 13.
(8) The lighting unit 10 is capable of being formed flexibly to some extent.

That is, the lighting unit 10 is capable of having an elasticity to some extent. Since the panels 11 are joined together through gel, even if a certain degree of power is applied to the lighting unit 10, a possibility of breaking the connection of the adjacent panels 11 is reduced.
(9) The panels 11 are individually exchanged.

A defective portion of the lighting unit 10 is eliminated by individually exchanging defective panels 11 for new panels 11, thereby being capable of extending a lifetime of the lighting unit 10 in comparison with a case where the lighting unit 10 of the same size is formed by one EL element, and a case where the panels 11 are not individually exchanged. Especially, in comparison with the aforementioned first to third prior art solutions, the panels of the same structure are adopted. In addition, it rarely occurs that a special operation upon exchange is required.

It is noted that the lighting unit of the second preferred embodiment is similar to that of the first preferred embodiment and the main object is not changed. In addition, the lighting unit of the second preferred embodiment may be modified as follows. It is also naturally possible to appropriately combine these modified examples.

The space between the end faces of the transparent substrate 13 may be constructed so that a gel, a light scattering member and a gel are arranged in this order.

Thus, a closely contacting performance and an elastic performance is caused by the gel to have the aforementioned effects. In addition, for a light scattering member, the light scattering member similar to that of the lighting unit according to the first preferred embodiment may be adopted.

The light scattering member 20 may be made of a slurry-material or a liquid in place of gel. In this case, it is preferable to create a seal between the end faces of the transparent substrate 13 so that the material stays in a space between the end faces. For a sealing method, for example, the sealing method similar to the protective film and the sealed can of the organic EL element 14 may be adopted.

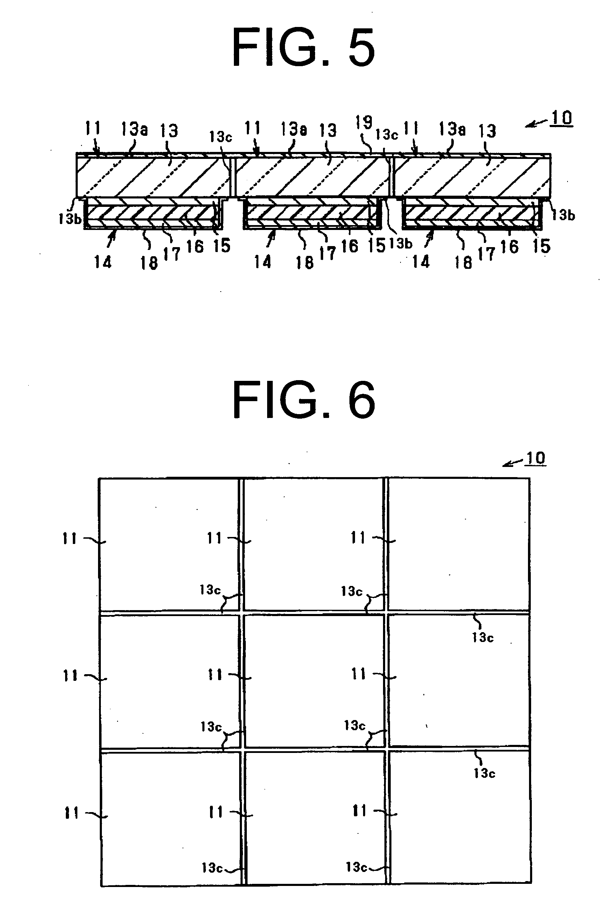

A lighting unit according to a third preferred embodiment of the present invention will now be described with reference to FIGS. 5 and 6. FIG 5 is a schematic sectional view illustrating the lighting unit according to the third preferred embodiment of the present invention. FIG. 6 is a schematic plan view illustrating the lighting unit according to the third preferred embodiment of the present invention. It is noted that the same numeric designations are used for components in common with the lighting unit according to the first and second preferred embodiments, and a detailed explanation in common with the first and second preferred embodiments is omitted.

In the third preferred embodiment, an end face 13c of the transparent substrate 13 of the panel 11 is roughened for a light scattering means, and the end face 13c functions as a second light scattering means. That is, an additional member functioning as a light scattering means is not needed as described in the first and second embodiments.

Specifically, the lighting unit 10 of the third preferred embodiment is constructed by arranging a plurality of panels 11 each including the transparent substrate 13 which has the light exit surface 13a and the light incidence surface 13b that are arranged on the opposite sides thereof, and the organic EL element 14 formed on the light incidence surface 13b of the transparent substrate 13. The light incidence surfaces 13b or the light exit surfaces 13a of the panels 11 are positioned roughly in the identical plane, and the organic EL element 14 of each panel 11 is placed so as to exist on the same side relative to the plane. The end faces 13c of each transparent substrate 13 function as a light scattering means, and the light exited from the EL element 14 is extracted from the lighting unit 10 to the outside thereof through the light exit surface 13a of the transparent substrate 13.

The end face 13c functions as a light scattering means, for example, by forming a plurality of uneven portions each having enough size to be capable of scattering light, or by sticking a plurality of transparent members whose refractive index is different from that of the transparent substrate to each other.

The light which has reached (has been guided to) the end face 13c of the transparent substrate 13 is scattered by the end face 13c functioning as a light scattering means, thereby enabling a part of or all the light to be "extracted" from the lighting unit 10 to the outside thereof. That is, the "extracted" light is capable of being "utilized".

It is noted that the lighting unit 10 may further provide a light scattering member between the adjacent panels. Such a structure enables a part of or all the light which has not extracted from the lighting unit 10 to the outside thereof by the end face 13c to be extracted.

In addition, the lighting unit 10 of the third preferred embodiment is similar to those of the first and second preferred embodiments and the main object is not changed.

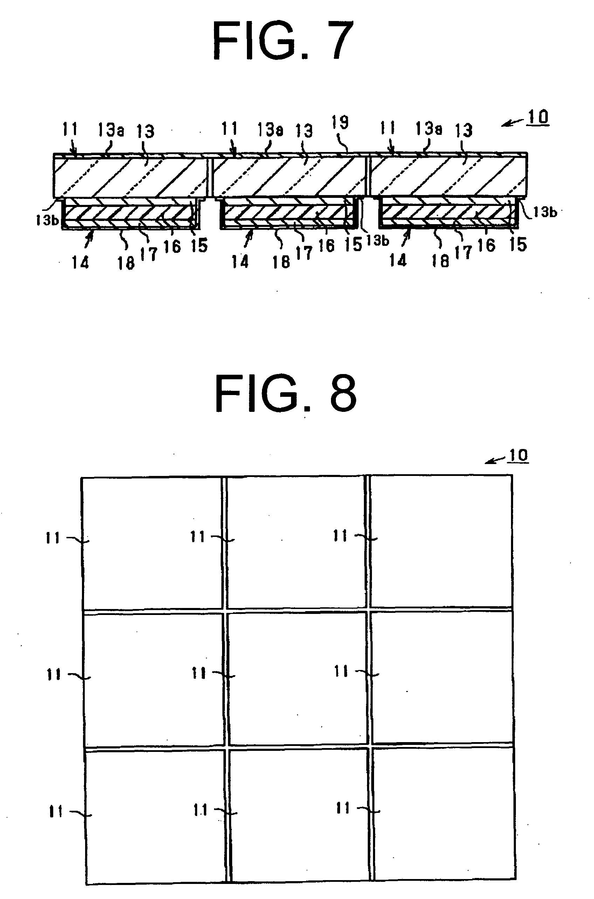

A lighting unit according to a fourth preferred embodiment of the present invention will now be described with reference to FIGS. 7 and 8. FIG. 7 is a schematic sectional view illustrating the lighting unit according to the fourth preferred embodiment of the present invention. FIG. 8 is a schematic plan view illustrating the lighting unit according to the fourth preferred embodiment of the present invention. It is noted that the same numeric designations are used for components in common with the lighting unit according to the first and second preferred embodiments, and the detailed explanation in common with the first and second preferred embodiments is omitted.

The lighting unit 10 of the fourth preferred embodiment is constructed by arranging a plurality of panels 11 each including the transparent substrate 13 having the light exit surface 13a and the light incidence surface 13b that are arranged on the opposite sides thereof, and the organic EL element 14 formed on the light incidence surface 13b of the transparent substrate 13. The light incidence surface 13b or the light exit surface 13a of the panel 11 are positioned roughly in the identical plane, and the organic EL element 14 of each panel 11 is placed so as to exist on the same side relative to the plane. The transparent substrate 13 provides the scattering member 19 on the side of the light exit surface 13a.

Even in this structure, the differentials between an amount of light emitted from a portion in which the organic EL element is provided and an amount of light emitted from a portion in which the organic EL element is not provided is averaged by using the scattering member 19, thereby reducing differentials in brightness between both of the portions. Especially, in a case where a width of the portion in which the organic EL element 14 is not provided is relatively narrow, the lighting unit 10 of the fourth preferred embodiment also sufficiently has the effects similar to the aforementioned effects.

It is noted that for the lighting unit 10 of the fourth preferred embodiment, as a matter of course, the aforementioned light scattering member may be arranged between the panels 11.

It is also noted that the "light scattering means" of the present specification is defined as a means for converting a traveling direction of incident light to various directions (a means having a function for scattering incident light).

It is also noted that the "light scattering structure" indicates a structure that converts a traveling direction of incident light to various directions. For example, a shape such as unevenness, and combination of a plurality of members whose refractive indexes are different from each other are disclosed.

It is also noted that "transparentness" mesns to permeate a part of incident light or all the incident light, and transmissivity may be different depending on wavelength.

It is also noted that although the "light" generally indicates a visible light in a range of about 380 nm to about 800nm, the "light" is used as conception including electromagnetic waves such as infrared rays and ultraviolet rays.

It is also noted that "scattering" means to convert a traveling direction of incident light by reflection or refraction.

Therefore, the present examples and embodiments are to be considered as illustrative and not restrictive and the invention is not to be limited to the details given herein but may be modified.

A lighting unit includes a plurality of panels and a light scattering means. The panels are arranged adjacently. Each panel has a transparent substrate and an electroluminescent element that is provided on the transparent substrate. Each panel also has end faces. The adjacent panels are arranged so that the end faces thereof face each other. The light scattering means is interposed between at least the end faces of the adjacent panels.

## Claims

1. A lighting unit including a plurality of panels arranged adjacently, each panel having a transparent substrate and an electroluminescent element that is provided on the transparent substrate, **characterized in that** each panel has end faces, **in that** the adjacent panels are arranged so that the end faces thereof face each other, and **in that** a light scattering means is interposed between at least the end faces of the adjacent panels.

2. The lighting unit according to claim 1, further including an adhesive means through which the transparent substrates of the adjacent panels are joined to each other, the adhesive means functioning as the light scattering means at least when the adhesive means is solidified.

3. The lighting unit according to claim 1 or 2, wherein the light scattering means is made of a gel or substantially made of the gel.

4. The lighting unit according to any one of claims 1 through 3, further including a scattering member provided on a side of a light exit surface of the transparent substrate and/or uneven portions formed on the light exit surface.

5. The lighting unit according to claim any one of claims 1 through 4, wherein a plurality of the electroluminescent elements are electrically connected in series.

6. The lighting unit according to any one of claims 1 through 5, wherein each electroluminescent element emits white light.

7. A lighting unit including a plurality of panels arranged adjacently, each panel having a transparent substrate, which has on opposite sides thereof a light exit surface and a light incidence surface, each panel also having an electroluminescent element that is provided on the light incidence surface of the transparent substrate, **characterized in that** each panel has end faces, **in that** the light exit surfaces or the light incidence surfaces are positioned roughly in an identical plane, **in that** each electroluminescent element is located so as to exist on the same side relative to the plane, and **in that** a light scattering structure is provided on the end face of each transparent substrate, thereby extracting the light that is emitted from the electroluminescent element from a side of the light exit surface to an outside of the lighting unit.

8. The lighting unit according to claim 7, further including a light scattering means provided between the transparent substrates of the panels adjacent to each other.

9. The lighting unit according to claim 7 or 8, further including a scattering member provided on a side of the light exit surface of the transparent substrate and/or uneven portions formed on the light exit surface.

10. The lighting unit according to any one of claims 7 through 9, wherein a plurality of the electroluminescent elements are electrically connected in series.

11. The lighting unit according to any one of claims 7 through 10, wherein each electroluminescent element emits white light.

12. A lighting unit including a plurality of panels arranged adjacently, each panel having a transparent substrate, which has on opposite sides thereof a light exit surface and a light incidence surface, each panel also having an electroluminescent element that is provided on the light incidence surface of the transparent substrate, **characterized in that** each panel further has end faces, **in that** the light exit surfaces or the light incidence surfaces are positioned roughly in an identical plane, **in that** each electroluminescent element is located so as to exist on the same side relative to the plane, and **in that** a scattering member is provided on a side of the light exit surface of the transparent substrate and/or **in that** uneven portions are formed on the light exit surface.

13. The lighting unit according to claim 12, further including a light scattering means provided between the panels adjacent to each other.

14. The lighting unit according to claim 12 or 13, wherein a plurality of the electroluminescent elements are electrically connected in series.

15. The lighting unit according to any one of claims 12 through 14, wherein each electroluminescent element emits white light.
